(19) Europäisches Patentamt
European Patent Office
Office européen des brevets

(11) **EP 2 562 205 A1**

(12) **EUROPÄISCHE PATENTANMELDUNG**

(43) Veröffentlichungstag:
27.02.2013  Patentblatt 2013/09

(21) Anmeldenummer: 11178233.0

(22) Anmeldetag: 22.08.2011

(51) Int Cl.:
*C08J 5/18* (2006.01)    *C08L 67/00* (2006.01)
*C08L 79/00* (2006.01)    *H01L 31/00* (2006.01)
*H01L 31/04* (2006.01)    *H01L 31/048* (2006.01)

(84) Benannte Vertragsstaaten:
**AL AT BE BG CH CY CZ DE DK EE ES FI FR GB
GR HR HU IE IS IT LI LT LU LV MC MK MT NL NO
PL PT RO RS SE SI SK SM TR**
Benannte Erstreckungsstaaten:
**BA ME**

(71) Anmelder: **Rhein Chemie Rheinau GmbH
68219 Mannheim (DE)**

(72) Erfinder:
• **Eckert, Armin
  68794 Oberhausen (DE)**
• **Laufer, Wilhelm
  67158 Ellerstadt (DE)**

(74) Vertreter: **Siegers, Britta
Lanxess Deutschland GmbH
LIP Intellectual Property Rights
Gebäude Q 18
D-51369 Leverkusen (DE)**

(54) **Neue Folien für Solarzellen**

(57)  Die vorliegenden Erfindung betrifft neue Folien für Solarzellen, die sich durch eine verbesserte Hydrolysebeständigkeit auszeichnen, sowie die Solarzellen, enthaltend diese Folien.

**Beschreibung**

Die vorliegenden Erfindung betrifft neue Folien für Solarzellen, die sich durch eine verbesserte Hydrolysebeständigkeit auszeichnen, sowie die Solarzellen, enthaltend diese Folien.

Die Stromerzeugung mittels Photovoltaik hat nach dem beschlossenen deutschlandweiten Ausstieg aus der Kernenergie einen Aufschwung erfahren.

Bei der photovoltaischen Stromerzeugung wird bekanntermaßen Sonnenenergie mittels eines Siliziumzellen-Halbleiters direkt in elektrische Energie umgewandelt. Dieses Solarzellenelement erfährt allerdings eine Qualitätsminderung, wenn es in direkten Kontakt mit der Umgebungsluft gebracht wird. Darum wird ein Solarzellenelement im Allgemeinen zwischen einem Dichtungsmaterial und einem transparenten Oberflächenschutzmaterial (meistens Glas) und einem rückseitigen Oberflächenschutzmaterial (einer Rückseitenfolie zum Beispiel aus einem Polyesterharz, einem Fluorharz oder dergleichen) angeordnet, um eine Pufferwirkung zu erzielen und das Eindringen von Fremdkörpern und vor allem das Eindringen von Feuchtigkeit zu verhindern.

Fluorharze (Kunststoffe auf Basis von Polyvinylfluorid) eignen sich aufgrund ihrer Inertheit besonders für dieses Einsatzgebiet, allerdings sind diese so teuer in der Herstellung und häufig nicht in ausreichender Menge verfügbar, so das auf hydrolyseinstabile Polyesterharze ausgewichen wird. Die Entwicklungsarbeiten gehen daher vorrangig in Richtung Hydrolyseschutz der Polyesterharzschicht.

Zu diesem Zweck werden z.B. Carbodiimide eingesetzt, siehe EP-A 2262000. Dabei sind vor allem aliphatische Carbodiimide, wie z.B. Carbodilite® LA-1 bzw. Carbodilite® HMV-8CV, bevorzugt. Diese haben allerdings den Nachteil, nur in hohen Konzentrationen als Hydrolyseschutzmittel zu wirken.

Die Aufgabe der vorliegenden Erfindung bestand somit darin, Folien für Solarzellen auf Basis von Polyester bereitzustellen, die die Nachteile des Standes der Technik nicht aufweisen und vor allem hydrolysestabil sind.

Überraschenderweise wurde nun gefunden, dass Folien, enthaltend mindestens einen Polyester und 0,5 - 2,5 Gew.% mindestens eines polymeren aromatischen Carbodiimids auf Basis von 1,3,5-Triisopropyl-2,4-diisocyanatobenzol mit einer gewichtsmittleren Molmasse $M_w$ von 10000 bis 50000 g/mol die Nachteile des Standes der Technik nicht aufweisen.

Gegenstand der vorliegenden Erfindung sind daher Folien für Solarzellen, enthaltend mindestens einen Polyester und 0,5 - 2,5 Gew.%, bevorzugt 1,0 - 2,0 Gew.%, mindestens eines polymeren Carbodiimids auf Basis von 1,3,5-Triisopropyl-2,4-diisocyanatobenzol mit einer gewichtsmittleren Molmasse $M_w$ von 10000 bis 50000 g/mol, bezogen auf den Polyester.

Die Ermittlung der gewichtsmittleren Molmassen erfolgte mittels GPC (Gel-Permeations-Chromatographie), gemessen in Tetrahydrofuran (THF) gegen Polystyrol als Standard.

In einer Ausführungsform der vorliegenden Erfindung handelt es sich bei dem Polyester um Polyethylenterephthalat (PET), Polyethylennaphthalat (PEN), Polybutylenterephthalat (PBT), Polytrimethyleneterephthalat (PTT) und/oder Polycyclohexandimethanol-terephthalat (PCT). Dabei sind Polyethylenterephthalat (PET) und Polytrimethyleneterephthalat (PTT) besonders bevorzugt.

In einer weiteren Ausführungsform der Erfindung handelt es sich bei dem Polyester um ein Gemisch aus Polyestern. In diesem Zusammenhang ist ein Gemisch aus Polyethylenterephthalat (PET) und Polyethylennaphthalat (PEN) bevorzugt.

Bei den Polyestern handelt es sich um handelsüblich Substanzen, die z.B. bei den Firmen Invista, Novapet S. A., Lanxess Deutschland GmbH, Corterra Polymers (Shell Chemicals) oder auch Teijin DuPont, erhältlich sind.

Bei den Carbodiimide im Sinne der Erfindung handelt es sich vorzugsweise um aromatische Carbodiimide auf Basis von 1,3,5-Triisopropyl-2,4-diisocyanatobenzol mit einer gewichtsmittleren Molmasse $M_w$ von 20000 bis 30000 g/mol. Diese sind handelsüblich und sind z. B. bei der Firma Rhein Chemie Rheinau GmbH erhältlich.

Die erfindungsgemäßen Folien können auch weitere Additive enthalten, wie z. B. Pigmente, Farben, Füllstoffe, Stabilisatoren, Antioxidantien, Weichmacher, Verarbeitungshilfsstoffe, Vernetzer etc.

Die Herstellung der erfindungsgemäßen Folie erfolgt vorzugsweise nach dem folgenden Verfahren.

In einer Ausführungsform der Erfindung wird das polymere Carbodiimid auf Basis von 1,3,5-Triisopropyl-2,4-diisocyanatobenzol mit einer gewichtsmittleren Molmasse $M_w$ von 10000 bis 50000 g/mol in der gewünschten Konzentration mittels Kneter und/oder Extruder in den Polyester eingearbeitet.

In einer weiteren Ausführungsform der Erfindung wird das polymere Carbodiimid auf Basis von 1,3,5-Triisopropyl-2,4-diisocyanatobenzol mit einer gewichtsmittleren Molmasse $M_w$ von 10000 bis 50000 g/mol in Form eines Polyester-haltigen Masterbatches mittels Kneter und/oder Extruder in den Polyester eingearbeitet. Dabei beträgt die Konzentration des Carbodiimids im Masterbatch vorzugsweise 10-20 Gew.%.

Gegebenenfalls einzusetzenden Additive, Pigmente, Farben, Füllstoffe, Stabilisatoren, Antioxidantien, Weichmacher, Verarbeitungshilfsstoffe, Vernetzer werden vorzugsweise in einem Mischschritt mit dem polymeren Carbodiimid in den Polyester eingearbeitet. Die Dosierreihenfolge von Carboddimid und Additiv kann dabei beliebig gewählt werden.

Die Herstellung der Folie erfolgt vorzugsweise durch Mischen von Carbodiimid oder Carbodiimid-Masterbatch und Polyester in Schmelze und anschließender Schmelzextrusion, siehe auch EP-A 2262000.

Für die Schmelzextrusion sind folgende Geräte einsetzbar: Einwellen-, Doppelwellen- oder Mehrwellenextruder, Planetenextruder, Kaskadenextruder, kontinuierlich arbeitende Co-Kneter (Typ Buss) und diskontinuierlich arbeitende Kneter, z.B Typ Banbury und andere in der Polymerindustrie übliche Aggregate.

Die Folien können dabei in beliebiger Dicke hergestellt werden. Bevorzugt sind jedoch Schichtdicken zwischen 25 und 300 Mikrometer.

Gegenstand der vorliegenden Erfindung ist zudem die Verwendung der erfindungsgemäßen Folie in Solarzellen und dort vorzugsweise zum Abdichten und damit zum Schutz vor Umgebungseinflüssen, wie z.B. Feuchtigkeit und dem Eindringen von Fremdkörpern.

Gegenstand der vorliegenden Erfindung ist zudem ein Solarzellenmodul, enthaltend mindestens eine erfindungsgemäße Folie.

Solarzellen bestehen in der Regel aus mehreren Schichten aus unterschiedlichen Materialien, wie

- dem Frontglas, aus z.B. Glasscheiben oder transparenten Substraten, wie z.B. Polycarbonat,

- den Siliciumwafern, die einlaminiert sind in Einbettfolien, bestehend in der Regel in Ethylenvinylacetat,

- einer Rückseitenfolie aus Polyvinylfluorid und/oder Polyester und

- einem Aluminiumrahmen.

Zudem sind auch Solarzellen bekannt, in denen sich zwischen dem Frontglas und dem Siliciumwafer noch transparente Polymerschichten befinden, z.B. aus α-Olefin-Vinylacetat-Copolymeren, mit Olefinen, ausgewählt aus Ethen, Propen, Buten, Penten, Hexen, Hepten und Octen, wie z.B. beschrieben in EP-A 2031662.

In der vorliegenden Erfindung wird die erfindungsgemäße Folie in Solarzellen als Rückseitenfolie eingesetzt. Dabei ist die Folie in allen im Stand der Technik bekannten Solarzellen einsetzbar.

Die Herstellung der Solarzelle erfolgt dabei nach den in dem Stand der Technik beschriebenen Verfahren, ausgehend von den Standardverfahren zur Herstellung von Silizium über Gießverfahren, Bridgeman Verfahren, EFG (edgedefined film-fed growth)- Verfahren oder dem Czochralski-Verfahren und der nachfolgenden Herstellung der Si-Wafer und dem Aufeinanderschichten der vorgenannten Materialschichten, wobei anstelle der standardmäßig eingesetzten Rückseitenfolie, die erfindungsgemäße Folie eingesetzt wird. Die einzelnen Schichten der Solarzelle können dabei auch in Laminierverfahren miteinander verbunden werden, siehe EP-A 2031662.

Der Rahmen der Erfindung erfasst alle oben stehenden und im Folgenden aufgeführten allgemeinen oder in Vorzugsbereichen genannten Restedefmitionen, Indizes, Parameter und Erläuterungen untereinander, also auch zwischen den jeweiligen Bereichen und Vorzugsbereichen in beliebiger Kombination.

Die nachfolgenden Beispiele dienen der Erläuterung der Erfindung, ohne dabei limitierend zu wirken.

**Ausführungsbeispiele:**

In den Beispielen wurden die folgenden Substanzen eingesetzt:

PET = Polyethylenterephthalat erhältlich bei der Firma Novapet, eingesetzt in den Beispielen 1 und 3-7.

In Bsp. Nr. 2 wurde das zuvor genannten PET in einem Labordoppelschneckenextruder ZSK 25 der Firma Werner & Pfleiderer vor der unten beschriebenen Messung einmal extrudiert.

Stabaxol® 1 LF, Bis-2,6-Diisopropylphenylcarbodiimid, erhalten bei der Firma Rhein Chemie Rheinau GmbH, eingesetzt in Beispiel 3.

Ein polymeres Carbodiimid auf Basis von 1,3,5-Triisopropyl-2,4-diisocyanatobenzol mit einer gewichtsmittleren Molmasse $2000 < M_w < 5000$ g/mol, eingesetzt in Beispiel 4.

Stabaxol® P 400: 1,3,5-Triisopropyl-2,4-diisocyanatobenzol mit einer gewichtsmittleren Molmasse $M_w$ von 21700 g/mol, eingesetzt in Beispiel 5.

Carbodilite® LA 1, ein polymeres aliphatisches Carbodiimid auf Basis von Dicyclohexylmethan-4,4'-diisocyanat (H12MDI) mit einer gewichtsmittleren Molmasse $M_w > 20000$ g/mol, der Firma Nisshinbo Chemical Inc., eingesetzt in Bsp. Nr 6.

Carbodilite® HMV-8 CA, ein polymeres aliphatisches Carbodiimid auf Basis von Dicyclohexylmethan-4,4'-diisocyanat (H12MDI) mit einer gewichtsmittleren Molmasse $M_w$ von ca. 10000 g/mol, der Firma Nisshinbo Chemical Inc., eingesetzt in Bsp. Nr 7.

Die Einarbeitung der Carbodiimide in das PET erfolgte mittels eines Labordoppelschneckenextruders ZSK 25 der Firma Werner & Pfleiderer.

Art und Menge des eingesetzten Carbodiimids ergeben sich aus Tabelle 1, ebenso wie die Messergebnisse in Bezug auf die Hydrolysestabilität.

Die für die Messung der Bruchdehnung wurden F3-Normprüfkörper an einer Spritzgießmaschine des Typs Arburg Allrounder 320 S 150 - 500 erstellt.

Für den Hydrolysetest wurden dieses F3-Normprüfkörper in Wasserdampf bei einer Temperatur von 120°C für 24 Stunden gelagert und deren Bruchdehnung nach 0 und 24 Stunden gemessen.

Die Ermittlung der gewichtsmittleren Molmassen erfolgte mittels GPC (Gel-Permeations-Chromatographie), gemessen in THF gegen Polystyrol als Standard. Zu diesem Zweck wurde ein Messgerät der Firma Thermo Scientific eingesetzt.

Die in Tabelle 1 angegebenen Werte ergeben sich aus der folgenden Berechnung:

$$\text{Bruchdehnung [\%]} = (\text{Bruchdehnung nach 24 Stunden} / \text{Bruchdehnung nach 0 Stunden}) \times 100$$

Tabelle 1

| Bsp. Nr | 1 | 2 | 3 | 4 | 5 | 6 | 7 |
|---|---|---|---|---|---|---|---|
| | V | V | V | V | E | V | V |
| Menge CDI [%] | 0 | 0 | 1,5 | 1,5 | 1,5 | 1,5 | 1,5 |
| Bruchdehnung [%] | 38 | 36 | 84 | 89 | 95 | 31 | 5 |
| V = Vergleichsversuch, E = erfindungsgemäß | | | | | | | |

Es zeigt sich, dass bei der Verwendung von 1,3,5-Triisopropyl-2,4-diisocyanatobenzol mit einer gewichtsmittleren Molmasse $M_w$ von 20000 g/mol die höchste Hydrolysestabilität erreicht werden kann.

**Patentansprüche**

1. Folie enthaltend mindestens einen Polyester und 0,5 - 2,5 Gew.% mindestens eines polymeren Carbodiimids auf Basis von 1,3,5-Triisopropyl-2,4-diisocyanatobenzol mit einer gewichtsmittleren Molmasse $M_w$ von 10000 bis 50000 g/mol, bezogen auf den Polyester.

2. Folie nach Anspruch 1, **dadurch gekennzeichnet, dass** es sich bei dem Polyester um Polyethylenterephthalat (PET), Polyethylennaphthalat (PEN), Polybutylenterephthalat (PBT), Polytrimethyleneterephthalat (PTT) und/oder Polycyclohexandimethanol-terephthalat (PCT) handelt.

3. Folie nach Anspruch 1 oder 2, **dadurch gekennzeichnet, dass** der Anteil an Carbodiimid 1,0 - 2,0 Gew.% beträgt.

4. Folie nach einem oder mehreren der Ansprüche 1 bis 3, **dadurch gekennzeichnet, dass** die gewichtsmittlere Molmasse $M_w$ des Carbodiimids 20000 bis 30000 g/mol beträgt.

5. Solarzellenmodul, enthaltend mindestens eine Folie nach einem oder mehreren der Ansprüche 1 bis 4.

6. Verwendung einer Folie nach einem oder mehreren der Ansprüche 1 bis 4 zum Abdichten der Solarzelle.

**EP 2 562 205 A1**

Europäisches Patentamt
European Patent Office
Office européen des brevets

# EUROPÄISCHER RECHERCHENBERICHT

Nummer der Anmeldung

EP 11 17 8233

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X,D | EP 2 262 000 A1 (TEIJIN DUPONT FILMS JAPAN LTD [JP]) 15. Dezember 2010 (2010-12-15) * Absätze [0001] - [0081]; Ansprüche 1-5 * ----- | 1-6 | INV. C08J5/18 C08L67/00 C08L79/00 H01L31/00 H01L31/04 H01L31/048 |

RECHERCHIERTE SACHGEBIETE (IPC)

C08J
C08L
H01L

Der vorliegende Recherchenbericht wurde für alle Patentansprüche erstellt

| Recherchenort | Abschlußdatum der Recherche | Prüfer |
|---|---|---|
| München | 16. Januar 2012 | Ansorge, Markus |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

.....................................................................

& : Mitglied der gleichen Patentfamilie, übereinstimmendes Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 11 17 8233

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

16-01-2012

| Im Recherchenbericht angeführtes Patentdokument | Datum der Veröffentlichung | Mitglied(er) der Patentfamilie | Datum der Veröffentlichung |
|---|---|---|---|
| EP 2262000 A1 | 15-12-2010 | CN 101983432 A<br>EP 2262000 A1<br>KR 20110000563 A<br>TW 201000555 A<br>WO 2009123357 A1 | 02-03-2011<br>15-12-2010<br>03-01-2011<br>01-01-2010<br>08-10-2009 |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 2262000 A

- EP 2031662 A

**In der Beschreibung aufgeführte Nicht-Patentliteratur**

- *Spritzgießmaschine des Typs Arburg Allrounder,* vol. 320, 150-500